# EUROPEAN PATENT SPECIFICATION

(11) **EP 2 135 106 B1**
(45) Date of publication and mention of the grant of the patent: **29.07.2015**
(21) Application number: 08743511.1
(22) Date of filing: 21.02.2008
(51) Int. Cl.: G01R 33/28, G01R 33/31, G01R 33/38, F25B 9/14, G01R 33/3815, F25D 19/00, G01R 33/30

(54) **METHOD AND APPARATUS TO HYPERPOLARIZE A MATERIAL TO BE USED IN MRI**
VERFAHREN UND VORRICHTUNG ZUR HYPERPOLARISIERUNG VON MATERIALIEN ZUR VERWENDUNG IN DER MR-BILDGBUNG
PROCÉDÉ ET APPAREIL PERMETTANT D'HYPERPOLARISER DES SUBSTANCES DESTINÉES À ÊTRE UTILISÉES DANS UNE IRM

(30) Priority: 02.04.2007 US 695411
(43) Date of publication of application: 23.12.2009
(73) Proprietor: General Electric Company, Schenectady, NY 12345 (US)
(72) Inventor: URBHAN, John, A., Saratoga Springs, NY 12866 (US); ARDENKJAER-LARSEN, Jan, DK-1808 Frederiksberg C (DK); STAUTNER, Ernst, W., Niskayuna, NY 12309 (US); AMM, Bruce, C., Clifton Park, NY 12065 (US); FEENAN, Peter, J., Oxford, Great Britain OX29 8AN (GB); MANGANO, Roy, A., Pewaukee, WI 53072 (US); REEVES, David, G., Bloxham, Oxfordshire OX15 4QE (GB)
(74) Representative: Bedford, Grant Richard
(86) International application number: PCT/US2008/054554
(87) International publication number: WO 2008/121458

(56) References cited:
- WO-A-01/96020
- WO-A-02/37132
- WO-A-2005/114244
- WO-A-2006/011810

## Description

The invention relates generally to a method and apparatus for polarizing samples for use in magnetic resonance imaging (MRI).

The present invention relates to nuclear magnetic resonance (NMR) analysis, particularly to nuclear magnetic resonance imaging (MRI) and analytical high-resolution NMR spectroscopy. MRI is a diagnostic technique that has become particularly attractive to physicians as it is non-invasive and does not involve exposing the patient under study to potentially any such as from X-rays. Analytical high resolution NMR spectroscopy is routinely used in the determination of molecular structure.

MRI and NMR spectroscopy lack some degree of sensitivity due to the normally very low polarization of the nuclear spins of the contrast agents typically used. A number of techniques exist to improve the polarization of nuclear spins. These techniques are known as hyperpolarization techniques and lead to an increase in sensitivity. In hyperpolarization techniques, a sample of an imaging agent, for example ¹³C₁-Pyruvate or another agent, is introduced or injected into the subject being imaged. As used herein, the term "polarize" refers to the alignment of the nuclear spins of an agent for further use in MRI. Further, as used herein, the term "hyperpolarized" refers to polarized to a level over that found at room temperature and at 1 T, which is further described in US 6,466,814.

In many instances, the imaging agent undergoes this hyperpolarization in an apparatus in close proximity to its end use. This is due to the normally short life time (longitudinal relaxation time T1) of the polarization causing the spins to relax back to the thermal equilibrium polarization. One such technique to polarize nuclear spins uses Dynamic Nuclear Polarization to polarize the spins in the solid state. The apparatus used to produce the hyperpolarized samples is provided with a low temperature space that is in a magnetic field. As typically constructed, the apparatus is equipped with a flow cryostat that includes a vacuum insulated chamber inserted into the bore of a magnet. The cryostat is cooled by way of a stream of a cold cryogen provided by an external cryogen supply through a transfer line and pumping device, and the flow of cryogen into the flow cryostat cools the bore of the magnet and forms the low temperature space.

The pumping devices currently used to provide the stream of cold cryogen are open cycle pumping systems that are undesirable for use in a clinical setting for numerous reasons. First, the open cycle pumping systems are large and generate high levels of noise. Furthermore, the open cycle pumping systems are expensive and cumbersome to operate because of the large quantity of cryogen that is consumed in the pumping process. That is, in order to provide a stream of cold cryogen to the flow cryostat, a sizable portion of the liquid cryogen is evaporated. In an open cycle pumping system, a large measure of this evaporated cryogen is not reclaimable. Thus, a large amount of cryogen is needed to hyperpolarize a sample, which adds significantly to the cost of operating the system.

In addition to adding cost to the operation of the pumping system, the failure to reclaim the evaporated cryogen in an open cycle pumping system also leads to overall system inefficiency. That is, continuous operation of an open cycle pumping system is not possible because of the cryogen loss associated with the hyperpolarization of each imaging agent sample. Therefore, continuous operation for the open cycle systems is only obtained by regular cryogen filling in intermediate reservoirs.

Thus, current hyperpolarization systems are inefficient and expensive to operate. A need therefore exists for a hyperpolarization system that minimizes or eliminates cryogen consumption and is energy efficient. It is also desirable that an improved hyperpolarization system be designed to operate in a manner that minimizes disruption to the surrounding environment and allow for more continuous operation, without the requirement of the operator to handle liquid cryogens, to increase production of hyperpolarized imaging agent samples.

Various such conventional systems are described, for example, in WO 2005/114244, WO 02/37132 and WO 01/96020. WO2005/114244 discloses a polarizer system in accordance with the preamble of present claim 1.

The present invention as defined by the appended claims overcomes the aforementioned drawbacks by providing an apparatus and method for producing hyperpolarized samples for use in magnetic resonance systems. A sorption pump is incorporated into the apparatus to create a closed system for hyperpolarizing.

Various other features and advantages of the present invention will be made apparent from the following detailed description and the drawings.

The drawings illustrate an embodiment presently contemplated for carrying out the invention.

In the drawings:
Fig. 1 is a block diagram and schematic of an apparatus to hyperpolarize materials according to an embodiment of the current invention.
Fig. 2 is a cross-sectional view of a sample path and holding container arrangement according to an embodiment of the current invention.
Fig. 3 is a cross-sectional view of a sample path and holding container arrangement according to another embodiment of the current invention.
Fig. 4 is a cross-sectional view of a sample path and holding container arrangement according to another embodiment of the current invention.
Fig. 5 is a cross-sectional view of a sorption pump according to an embodiment of the current invention.

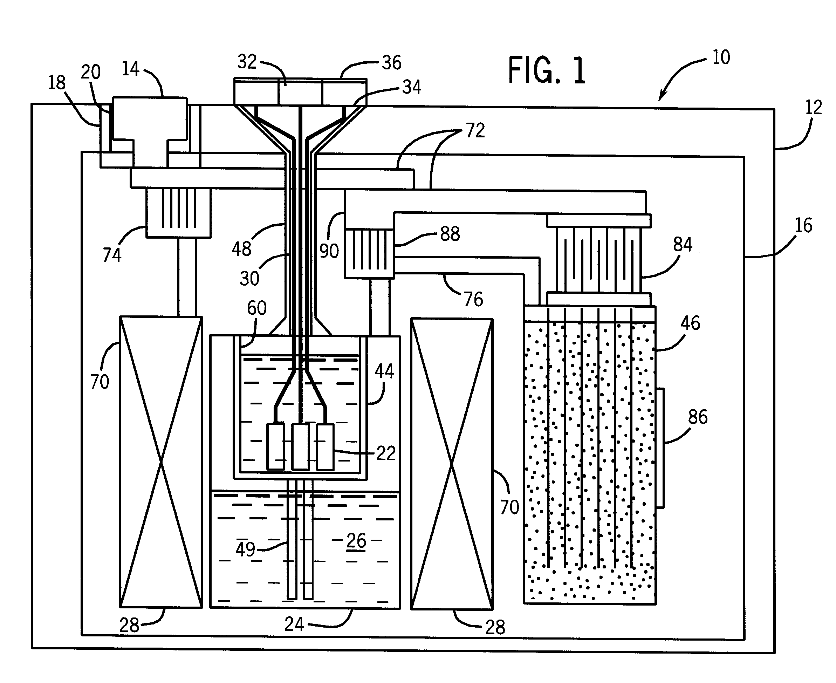

Referring to Fig. 1, an apparatus for hyperpolarizing a material for use in nuclear magnetic resonance (NMR) and magnetic resonance imaging (MRI) is shown. The polarizer system 10 is a closed cyclical thermal system configured to hyperpolarize a sample of an imaging agent for use in MRI. For example, the sample can be composed of ¹³C₁-Pyruvate or another agent that can be polarized. Polarizer system 10 is formed in part by a vacuum chamber 12 that surrounds the internal components of the system. Polarizer system 10 also includes a thermal shield 16 within the vacuum chamber 12. Thermal shield 16 surrounds the main components of the polarizer system 10 and functions to reduce the radiative heat load to those components. In one embodiment, the thermal shield 16 is composed of aluminum and is insulated with twenty or more layers of a highly insulative material, such as multilayer insulation (MLI).

A refrigerator 14 that functions as a cooling system for the polarizer system is also included and can be selected from a number of refrigerators (cold-heads or cryo-coolers) that are known and are commonly used on MRI magnets. The refrigerator 14 is positioned, at least in part, externally from vacuum chamber 12. Such a configuration allows any heat generated by the refrigerator 14 to be exhausted in the ambient environment rather than into the interior of vacuum chamber 12.

In one embodiment, refrigerator 14 is a closed cycle refrigerator capable of providing low temperature environments below 10 K. A separate vacuum enclosure 18 is provided for the refrigerator 14. The refrigerator itself is mounted in a vertical orientation within a mobile sleeve 20 to allow for vertical movement of the refrigerator 14 therein. The refrigerator 14 is further characterized in being field serviceable. That is, the cryostat design is such that the refrigerator 14 can be switched off and removed for a time that will allow a service engineer to replace or service the refrigerator. The polarizer system 10 is immune to such a procedure and is configured to continue operation for a period of time while refrigerator is shut off.

Referring still to Fig. 1, the substance or material to be polarized (e.g., ¹³C₁-pyruvate), hereafter referred to as sample 22, is positioned within vacuum chamber 12 for hyperpolarization. To allow for hyperpolarization of the sample 22, the sample is placed in container 24 having a cryogenic refrigerant 26 therein. In one embodiment, the cryogenic refrigerant is in the form of a liquid helium bath 26 into which the sample 22 is at least partially immersed. Container 24 is sealable and can be evacuated to low pressures (e.g. pressures of the order of 100 Pa (1 mbar) or less) as will be explained in greater detail below. To allow for hyperpolarization of the sample 22, the temperature of liquid helium bath 26 is lowered to a suitable temperature, e.g. temperatures below 4.2 K and preferably below 1.5 K. The sample 22 is then placed in a suitable magnetic field by magnetic field producing device 28 positioned about container 24 to achieve hyperpolarization.

The samples 22 are introduced into the polarizer system 10 by way of a sample path 30 that passes through an ante chamber 32 (i.e., air lock). The purpose of the ante chamber 32 is to prevent contamination of the sample path 30 during introduction of the samples 22 and also to eliminate the need of breaking the vacuum on the sample path 30. In existing polarizer systems in the art, the sample path is pressurized to atmospheric pressure with helium gas; however, this is a major limitation of existing polarizers since bringing the sample path pressure to atmospheric pressure constitutes a significant heat load to the liquid helium bath and also transiently raises the temperature of the bath, i.e. reduces the throughput. In one embodiment of the present invention, the ante chamber 32 is isolated from vacuum chamber 12 by a gate valve 34 and from the atmosphere by a sealing cap 36. The ante chamber 32 can then, once the sample 22 has been introduced, be evacuated and flushed with helium gas in several cycles to eliminate and evacuate any air (and moisture). Thus, ante chamber 32 reduces the heat load to the liquid helium bath 26. The specific design of the ante chamber 32 will vary based on the geometry of the sample 22 and can be designed accordingly in a way known to one skilled in the art.

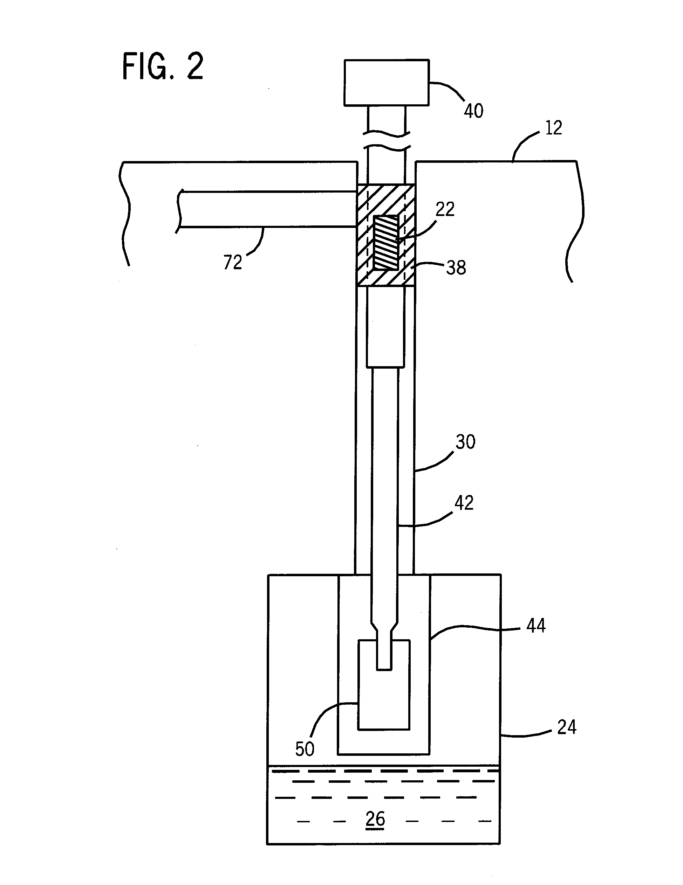

Referring now to Fig. 2, the sample path 30, and the internal surfaces thereof exposed to the sample 22, are made from materials that are routinely used for pharmaceutical equipment and should follow such industry standards. A portion of the sample path 30 can be filled with liquid helium dispensed through a sterile filter to further minimize the bio-burden in this area. The sample path 30 is further characterized in having an equilibrator 38 that serves the purpose of leading the heat of the samples 22 to the refrigerator 14 before the sample 22 is introduced into the helium bath 26. The latent heat of the sample 22 would constitute a very large heat load to the helium bath 26 significantly reducing the hold time of the system. Depending on the heat capacity properties of the sample 22, this energy is easily predictable and/or measured, and the time required to sit in the equilibrator 38 will depend on the rate of heat conduction in the sample 22, from the sample to the equilibrator 38, and on the rate of heat conduction away from the equilibrator 38. An optimized design can be made based on the above parameters and the temperature at which the sample 22 is allowed to enter the bath 26. The equilibrator 38 can be designed in several ways by a person skilled in the art. The main characteristics are low conductivity to the bath 26 and good conductivity from the sample 22 to the refrigerator 14. The good conductivity from the sample 22 can be obtained by good physical contact between the sample 22 and a high conductivity material, but in many cases the helium gas present in the sample path 30 will act as a sufficient exchange gas and efficiently conduct the heat from the sample 22 to the walls of the equilibrator 38.

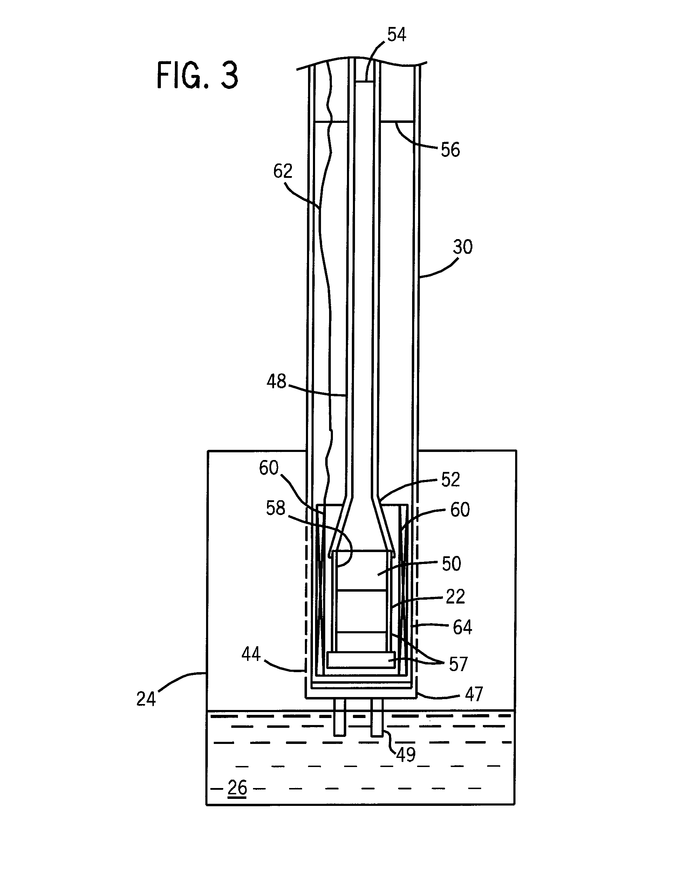

The sample path 30 can also be equipped with a means of providing heat to the sample during a dissolution process or a means to mechanically agitate the sample during the dissolution. In one embodiment, once the sample 22 has been hyperpolarized to a desired state, the sample is dissolved by way of a heated solvent flowing thru sample 22 and is removed from the polarizer system 10 via the sample path 30 to a desired location/user. Referring now to Fig. 3, in another embodiment, the means for mechanically agitating the sample 22 is an ultrasound transmitter 40 that vigorously agitates the solvent and facilitates the dissolution. An ultrasonic burst is carried down the sample path 30 and into the sample by way of a sonicator probe 42 to break the solid sample and pressurize the surrounding environment to force the dissolved sample and solvent back up the sample path 30. The ultrasound would at the same time dissipate heat in the solution. While a heated solvent and ultrasound have been described as a means of providing energy to the sample, it is also envisioned that other methods/mechanisms for providing energy could also be implemented, such as infrared radiation or microwave energy.

Referring again to Fig. 1, the sample 22 is ultimately positioned in a holding container 44 that is in thermal contact with liquid helium bath 26 of container 24. The sample 22 is separated from liquid helium bath 26 by placing it inside the holding container 44. This placement of sample 22 into holding container 44 increases the longevity of the polarizer system 10 and improves system efficiency, as the sample loading inevitably introduces contamination into the polarizer system 10, which would in turn effect operation of a sorption pump 46 in the polarizer system. The sorption pump 46 is sensitive to contamination and cannot easily be restored, and thus, placement of sample 22 in the holding container 44 helps to prevent these contaminants from entering into liquid helium bath 26.

Referring now to Fig. 3, the holding container 44 is in thermal contact with liquid helium bath 26 by a common wall 47 with high thermal conductivity that minimizes the thermal gradient. If holding container 44 is not immersed in liquid helium bath 26, it also can be placed in thermal contact therewith by way of copper tails or fins 49 that extend down from the holding container 44 into the bath 26. The holding container 44 can also be filled in part with liquid helium. In such a configuration, the liquid helium acts as a good heat conductor from sample 22 to the walls 46 of the holding container and finally into the helium bath 26 of container 24. In one embodiment, the superfluid helium, which has very high heat conductivity, also serves to conduct dissipated microwave energy away from sample 22 that is directed thereto by a microwave irradiation system (not shown).

The need for liquid helium within holding container 44 is optional and will depend on the design of the microwave irradiation system, the sample properties, and the thermal contact to the sample 22. Rather that being filled with liquid helium, it is also envisioned that holding container 44 be filled with helium gas. The use of helium gas within holding container 44 for cooling sample 22 is desirable since this volume of helium may occasionally be evaporated and recondensed from, for example, a helium gas cylinder. Additionally, the helium gas can lead to improvement in the cryogenic performance of the polarizer system 10 by reducing the film flow from the helium bath if operated above the lambda point of helium.

To focus and confine the microwaves to sample 22, so as to provide for efficient polarization thereof, the holding container 44 contains a microwave confining arrangement that includes a waveguide 48 and optionally a sample cup 50. The microwave confining arrangement is designed in a way to deliver the microwave energy (microwave magnetic field) required for the DNP process. For example, if the magnetic field for polarization is chosen in the range 1-20 T, the microwave field would be in the range 3-560 GHz for a g=2 paramagnetic agent. In the embodiment of waveguide 48 shown in Fig. 1, microwaves are transmitted into the sample by waveguide 48, which extends down around sample path 30 and joins with holding container 44 to irradiate the sample 22. As shown in Fig. 3, in another embodiment, waveguide 48 and conical horn 52 form with sample cup 50 to irradiate sample 22. The waveguide 48 contains a vacuum-tight seal 54 therein, which can be constructed of a polymer, quartz, or sapphire window, and also contains baffles 56 at appropriate positions within the sample path 30 to reduce heat transfer down the sample path and into the holding container 44. In Fig. 3, the waveguide 48 is removable from the sample path 30 after hyperpolarization of the sample 22 has been achieved and before a desired dissolution of the sample is carried out.

Referring still to Fig. 3, the waveguide 48 joins with sample cup 50 at the lower end thereof to guide microwaves into the sample 22. The sample cup 50 has a thin layer metal wall 57 and bottom surface that confines these microwaves to the sample. Preferably, the sample cup is comprised of a titanium or gold, or another metallic material that will not react with the pyruvic acid of the sample or with the solvent used to dissolve the sample during dissolution. It is also envisioned that a plastic inner shell 58 could be included inside the metallic sample cup 57 to prevent contact between the sample and metal. The plastic inner shell 58 would also dictate heat conductivity of the sample cup 50, and thus inclusion of the inner plastic shell 58 may also depend on the selection of liquid or gaseous helium within holding container 44 and the desired amount of heat transfer between the sample cup and the helium. The waveguide 48 and sample cup 50 arrangement is designed to minimize losses and deliver a maximum of the microwave energy to the sample, as a higher loss in the microwave delivery system would require a more powerful microwave source. It is also envisioned that the microwave delivery system is part of the sample 22 to confine the microwave entirely to the sample 22.

In one embodiment, a NMR coil 60 is also included in the overall structure of the holding container 44. The NMR coil 60 is optional, but provides a means of measuring the nuclear polarization during and after the DNP polarization process by producing RF pulses that measure the polarization level of the sample 22. A number of arrangements for an NMR coil 60 are known in the art, and in a preferred embodiment, the NMR coil 60 is positioned outside the microwave confining arrangement. The NMR coil 60 can be a saddle coil, Helmholz coil, birdcage coil, or any other known design. The NMR coil 60 is connected to the outside of vacuum chamber 12 by, for example, a coaxial cable 62 or other suitable radio frequency cabling. In one embodiment, the NMR coil 60 is positioned inside of the holding container 44, although it is envisioned that NMR coil 60 could also be positioned outside of the holding container 44. The walls of the holding container 44 can be slit in such a way as to minimize losses and ensure radio frequency penetration. That is, the holding container 44 could, in part, be formed of copper and slit as desired to allow RF signals to penetrate therethrough and include a plastic inner shell 64 to provide a sealed holding container 44. To also allow the RF signals to penetrate into the sample 22, the thickness of the sample cup 50 walls is kept within a desired range such that the RF waves are not severely attenuated by the metallic sample cup.

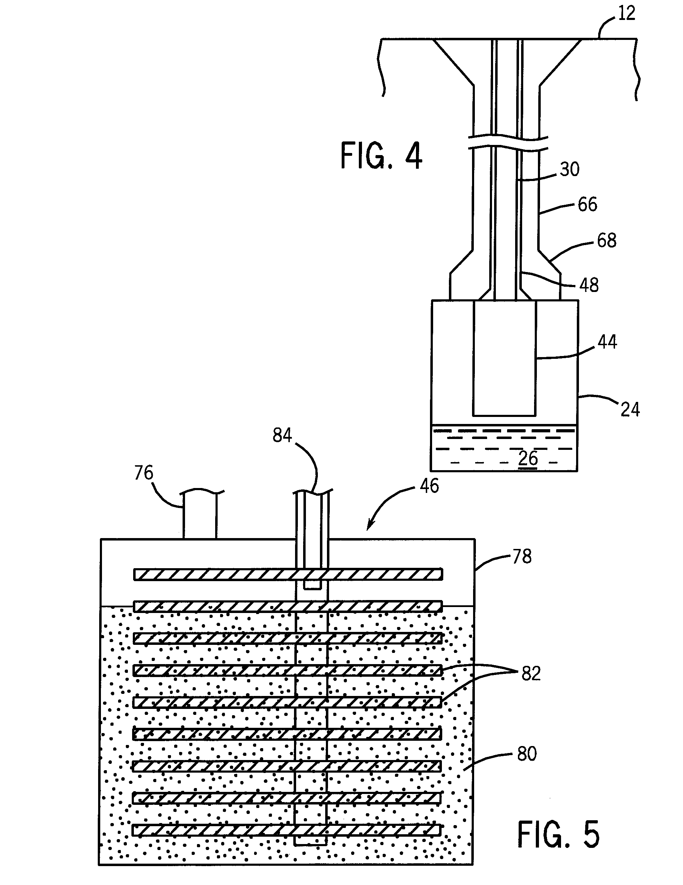

Referring now to Fig. 4, according to one embodiment, sample path 30 is configured to be removable in the field without de-energizing the magnet and breaking the cryostat vacuum. This allows for regular field service of the polarizer system 10 while causing minimal disruption to the operation thereof. The sample path 30 can require field service for a number of reasons, such as failure of the NMR coil 60 or waveguide 48 transmission systems (shown in Fig. 1) for electrical or mechanical reasons, contamination of the sample path 30 by ingression of air that cannot be removed by a standard operation procedure, or failure of the sample 22 at any stage of the process. Detachable sample path 30 is mounted in a stainless steel sleeve 66 that isolates the sample path vacuum from the remaining cryostat vacuum 12 and is sealed to holding container 44 via an indium gasket 68 to allow for evacuation of the sleeve 66. This would allow the sample path vacuum to be broken without disrupting operation of the rest of the polarizer system 10 and for removal of the sample path 30. The sample path 30 also includes a bolted room temperature flange (not shown) sealed by standard vacuum techniques. It is also envisioned that other configurations could be implemented for the detachable sample path 30.

Referring again to Fig. 1, one embodiment of magnetic field producing device 28 is shown positioned about container 24 and the liquid helium bath 26. Magnetic field producing device 28 is a superconducting magnet having a bore therethrough in which container 24 is placed. Superconducting magnet 28 is capable of creating a magnetic field strength that is sufficiently high, e.g. between 1-25 T or more, for example 3.5 T, for hyperpolarization of the sample 22 to take place. To ensure efficient operation of superconducting magnet 28, the magnet is enclosed in a vessel 70 containing liquid helium to provide cooling. The liquid helium is in turn cooled by refrigerator 14 that is connected to magnet 28 by way of thermal buss 72. The magnet 28 is connected to the thermal buss 72 through a condenser 74, which is a standard configuration for superconducting magnets cooled by a refrigerator. The condenser 74 re-condenses into the magnet vessel 70 any helium gas that evaporates due to the heat load to the magnet 28. In the event that refrigerator 14 is disconnected for servicing or there is an electrical power failure, the thermal buss 72 will warm up. In response, the condenser 74 is isolated from the magnet 28 thereby maximizing the time that the magnet 28 will survive not being cooled by the refrigerator 14 and preventing quench or loss of cryogen. It is also envisioned that magnet 28 could be dry (i.e., no liquid helium), but the magnet would then only maintain its superconducting properties for a short time (i.e., until the magnet warms above its superconducting temperature) in case of the refrigerator 14 being turned off.

The magnet 28 can favorably be operated sub-atmospheric to minimize the heat load to the refrigerator 14 from the magnet. If the magnet 28 is operated sub-atmospheric, a protective buffer helium volume can be added to any safety exhaust ports on the polarizer system 10 to prevent ingression of air and contamination of the magnet or sorption pump.

The magnet 28 is designed such as to provide a high magnetic fringe field region away from the very low temperature container 24. This high field region, e.g. 1-25 T or more, for example 3 T, is required in many instances during the dissolution of the sample 22. That is, as the dissolved sample is transferred out from container 24 via the sample path 30 and outside the volume of the vacuum chamber 12, a fringe magnetic field is desirable to maintain the hyperpolarized state of the sample 22. Furthermore, the magnet 28 can be designed in way that the fringe field is axially contained via active or passive shielding. Along the sample path 30, the magnetic field is preferably high, at least to an extent that the relaxation of the sample polarization is minimized at all steps of the dissolution process. Depending on the properties of the sample 22, this fringe magnetic field can be adjusted in intensity and coverage area as needed.

The magnet 28 and cryostat are also designed in such a way as to minimize or tolerate the interaction with an imaging magnet (not shown). In some circumstances, it is preferable to position the polarizer system 10 as close as possible to a magnetic resonance (MR) system (not shown) and the imaging magnet contained therein. In such an arrangement, magnetic field homogeneity and magnetic forces need to be carefully controlled on both magnets in order to minimize interference of the two magnetic fields and maintain homogeneity of the MR imaging field.

Referring still to Fig. 1, container 24 is sealable and can be evacuated to low pressures. Evacuation of container 24 to a low pressure in turn reduces the temperature of liquid helium bath 26 by vaporizing a portion of liquid helium and moving the state point down the helium saturation curve. That is, the boiling temperature of liquid helium (4.2 K) is a function of its vapor pressure. By reducing the pressure on the liquid helium bath 26, it is possible to cool it, and the sample 22 therein, to about 1 K without any further complications. This low temperature then allows for transformation of the sample 22 to a high fractional polarization state that is desired.

To achieve this reduction in pressure on liquid helium bath 26, sorption pump 46 is fluidly connected to container 24 by way of a pumping line 76. Sorption pump 46 is configured to lower pressure in container 24 by adsorbing the gas that evaporates from liquid helium bath 26. Sorption pump 46 operates in this sorption mode (i.e., polarization/pumping phase) when the pump is lowered to a cryogenic temperature. That is, when sorption pump 46 is cooled to a temperature of ∼10 K or below, helium gas will evaporate from liquid helium bath 26 and be adsorbed by sorption pump 46 forming a monolayer or two on a sorbent material therein.

As shown in Fig. 5, sorption pump 46 includes a pump enclosure 78 containing a sorbent material 80 therein. Pump enclosure 78 is preferably in the form of a cylinder, although other suitable constructions may also be implemented. Sorbent material 80 is formed of a material having a high rate of adsorption at low temperatures. In one embodiment, sorbent material 80 is composed of activated charcoal, which has a high rate of adsorption due to its large total surface area, which is in the range of tens of square meters per gram (e.g., >1000 m²/g). Dispersed within sorbent material 80 are cooling fins 82 that cool the material. Cooling fins 82 promote uniform cooling of sorbent material 80 to improve the adsorption efficiency during a pumping or sorption cycle/phase. In one embodiment, cooling fins 82 are comprised of copper tubing so as to provide a medium having good thermal conductivity for quick cooling of the sorbent material 80. The cooling structure 82 can be arranged in many ways depending on the geometry of the enclosure 78 to provide quick cooling of the sorbent material 80.

In order to cool the sorbent material 80 as described above, cooling fins 82 are attached to a thermal switch 84 that connects and disconnects sorption pump 46 from refrigerator 14 according to operator commands. Referring back to Fig. 1, refrigerator 14 is connected to sorption pump 46 by way of primary thermal buss 72 (i.e., thermally conductive link) and thermal switch 84. Primary thermal buss 72 provides a link for refrigerator 14 to cool sorption pump 46 and the sorbent material 80 therein to a cryogenic temperature to allow the pump to operate in sorption mode. The conductive link provided by primary thermal buss 72 is selectively connected and disconnected from sorption pump 46 by way of thermal switch 84, thus allowing for the pump to also exit sorption mode when desired.

The sorption pump 46 and connected pumping line 76 are designed to create a high pumping capacity. This high pumping capacity is needed to obtain a low base temperature in the liquid helium bath 26 in a reasonable time. Upon adsorption of a sufficient number of molecules to reduce the temperature of liquid helium bath 26 to a desired temperature for hyperpolarization of the sample 22, the sorption pump 46 is configured to maintain the low temperature of the liquid helium bath 26 for an extended time during which hyperpolarization can occur. The exact capacity of the sorption pump 46 to absorb helium and the volume of liquid helium in bath 26 can be designed and optimized to give the desired hold time of the low temperature for hyperpolarization.

Upon completion of a desired sorption pumping phase in which samples 22 have been polarized, sorption pump 46 can be switched to a desorption mode (i.e., reheating/recondensing phase) to allow for the helium molecules adsorbed in sorbent material 80 to recondense and transfer back to container 24 to refill the liquid helium bath 26. Referring still to Fig. 1, in desorption mode, the temperature of sorption pump 46 is raised to a temperature such that helium molecules are desorbed from the sorbent material and released therefrom. To achieve this higher temperature, thermal switch 84 is positioned to disconnect the refrigerator 14 and primary thermal buss 72 from sorption pump 46. When disconnected from refrigerator 14, the temperature of sorption pump 46 is elevated by turning on heater 86, and enters desorption phase upon reaching a temperature of, for example, 30-40 K, wherein helium molecules escape from the sorbent material 80 and exit the sorption pump 46 via the pumping line 76. Ideally, sorption pump 46 is also allowed to enter a regeneration phase where the sorbent material 80 can be heated by heater 86 to a higher temperature to drive off water vapor collected therein that does not desorb at room temperature. This regeneration phase can take up to two hours, and as such, would be performed during periods when use of the polarizer system 10 is not required. The heating profile and desorption/regeneration temperatures are chosen to give the most optimal cryogenic performance.

As mentioned above, helium gas molecules that had previously been vaporized are allowed to recondense in the desorption phase. This recondensing is achieved by way of a helium condenser 88 that is connected to sorption pump by way of pumping line 76. Helium gas released from sorbent material 80 during the desorption phase exits sorption pump 46 by way of the pumping line 76 and is carried to helium condenser 88. Helium condenser 88 functions to cool the helium gas to a temperature necessary to place the helium in a liquid state. Once the helium has been recondensed into a liquid state, it reenters container 24 and liquid helium bath 26 is refilled. Helium condenser 88 is cooled by refrigerator 14 through connection thereto formed by common thermal buss 90. As shown in Fig. 1, common thermal buss 90 is connected to refrigerator 12 by way of primary thermal buss 72. Common thermal buss 90 then is connected to helium condenser 88 to allow for recondensing of the helium gas that enters into the condenser. It is also envisioned that common thermal buss 90 and primary thermal buss 72 can be formed as a single thermal buss.

The functioning of the polarizer system 10 as a closed system operating in a cyclical thermal cycle provides for an efficient system for hyperpolarizing the sample 22. Additionally, the amount of liquid helium consumed during hyperpolarization is reduced essentially to zero because of the sorption pump 46 and condenser 88 arrangement, thus reducing maintenance on the polarizer system as no liquid cryogens need to be filled and no mechanical pumps need to be serviced.

The polarizer system 10 heretofore described includes an adsorption pump 46 (i.e., sorption pump). While adsorption pumps have been used in a number of cryogenic applications, sorption pump 46 provides the unique benefits of having a very high adsorption capacity that translates into a high pumping capacity and long hold time. The polarizer system 10 also provides a single common refrigerator that is configured to cool both the superconducting magnet 28 and the sorption pump 46. The superconducting magnet cryogenic system (i.e., refrigerator 14 and liquid helium contained in magnet vessel 70) is designed in such a way to be insensitive to the thermal cycle of sorption pump 46. The sorption pump 46 is capable of reaching temperatures well below any currently available refrigerator. While the embodiment of polarizer system 10 described above implements sorption pump 46, it is also envisioned that a refrigerator with sufficient capacity and base temperature can provide an environment having cryogenic temperatures in the range of 1.5 K that are suitable for hyperpolarization, such as an Adiabatic Demagnetization Refrigerator (ADR), which has also been successfully operated in low temperature physics applications.

While polarizer system 10 has been described above as a self-contained system, it is also envisioned that the system be integrated with a MR imaging system. In such a configuration, an MR magnet functions to create the fringe magnetic field. With some local optimization of the strength and homogeneity of this fringe field, a sufficient DNP polarizing field needed for hyperpolarization of the ¹³C₁-pyruvate sample can be created. Additionally, a helium reservoir of the MR imaging system used to cool the imaging magnet could also be used to provide liquid helium to the container surrounding the sample to be polarized. One implementation would be to connect the main helium reservoir to the container/sample space of the polarizer system via a capillary with a needle valve and controlling inflow of liquid helium to the container by way of the valve. The integration of the polarizer system with a MR imaging system would lead to a more compact and cheaper overall design.

As discussed earlier with regard to the stand alone polarizer system, it is often desirable to lower the temperature of the sample during polarization beyond the boiling point of helium at atmospheric pressure (4.2 K) in order to achieve high nuclear polarization of the sample. To reach these lower temperatures, the sample space (containing a bath of liquid helium) may be pumped on constantly by a sorption pump, which will result in a reduction of the helium's vapour pressure and consequently in a lower operating temperature. In light of the integration of the polarization system and the MRI imaging system, it is favourable to re-circulate the cold helium gas that is pumped out of the sample space to add to the cooling effect of the MR imaging magnet to provide additional cooling capacity (resulting in a longer helium hold time and obliterating the implementation of a liquid nitrogen reservoir) and to have an advantageous effect on cryogenic hold-time.

In general, the use of the MR imaging magnet for hyperpolarization would facilitate maintenance, as liquid helium re-filling would be performed on only the one integrated system rather than at different times for the two separate magnets. The integrated system would also take advantage of the existing cryogenic safety features of the MR scanner and make use of MR scanner electronics to monitor the increasing NMR signal from the sample while the polarization process is on-going.

Therefore, according to one embodiment of the present invention, an apparatus to hyperpolarize a substance for use in enhancing magnetic resonance techniques includes a cooling chamber having a cryogenic refrigerant therein for use in polarizing a substance, a sorption pump connected to the cooling chamber to adjust a pressure therein and create low temperatures, and a refrigeration system to cool the sorption pump and promote molecular adsorption therein. The cooling chamber, the sorption pump, and the refrigeration system are arranged in a closed system.

In accordance with another embodiment of the present invention, a polarizer system to polarize a material to be used in magnetic resonance (MR) imaging includes a container having a liquid helium bath therein, wherein the material to be polarized is positioned in the liquid helium bath. The polarizer system also includes a sorption pump to reduce a pressure in the container and thereby vaporize a portion of the liquid helium bath, a cooling system to cool the sorption pump and promote molecular adsorption therein, and a thermally conductive link that selectively connects the sorption pump and the cooling system to provide selective cooling to the sorption pump. The polarizer system operates in a closed cyclical thermal cycle alternating between a polarizing phase and a reheating phase based on the connection of the sorption pump to the cooling unit.

In accordance with yet another embodiment of the present invention, a method for producing hyperpolarized material for use in magnetic resonance imaging (MRI) or nuclear magnetic resonance (NMR) spectroscopy systems includes the step of placing a material in a vessel containing a liquid helium bath. The method also includes the steps of reducing a temperature in the liquid helium bath by way of a sorption pump and polarizing the material when the liquid helium bath has been sufficiently cooled.

The present invention has been described in terms of the preferred embodiment, and it is recognized that equivalents, alternatives, and modifications, aside from those expressly stated, are possible and within the scope of the appending claims.

## Claims

1. A polarizer system (10) for polarizing a material (22) to be used in magnetic resonance (MR) imaging, the system comprising:
a container (24) having a liquid helium bath therein, wherein the material to be polarized is positioned in the liquid helium bath;
a sorption pump (46) operable to reduce a pressure in the container (24) and thereby vaporize a portion of the liquid helium bath;
a cooling system (14) operable to cool the sorption pump (46) and promote molecular adsorption therein;
a thermally conductive link (72) for selectively connecting the sorption pump (46) and the cooling system (14) to provide selective cooling to the sorption pump (46);
wherein the polarizer system (10) is arranged to operate in a closed cyclical thermal cycle alternating between a polarizing phase and a reheating phase based on the connection of the sorption pump (46) to the cooling system (14);
said polarizer system (10) further comprising a thermal switch (84) for connecting and disconnecting the thermally conductive link (72) from the sorption pump (46), wherein the thermal switch (84) is operable to connect the thermally conductive link (72) to the sorption pump (42) during the polarizing phase and disconnect the thermally conductive link (72) from the sorption pump (42) during the reheating phase;
a magnetic field producing device (28) for maintaining a selected magnetic field therein and wherein the magnetic field producing device (28) is cooled by the cooling system (14), wherein the magnetic field producing device (28) further comprises:
a magnet having a bore therethrough positioned about the container (24); and
a magnet vessel (70) to enclose the magnet, the magnet vessel (70) containing liquid helium therein to cool the magnet;
the polarizer system (10) further comprising a recondenser (74) attached to the magnet vessel (70) to recondense liquid helium boiled off therefrom;
**characterised in that**:
the magnet is a superconducting magnet, and **in that** the polarizer system (10) comprises
a helium condenser (88) connected to the sorption pump (46) by way of a pumping line (76), said helium condenser (88) being cooled by said cooling system (14) through a common buss (90) connected to the thermally conductive link (72), the helium condenser (88) being arranged to recondense helium gas released from sorbent material in the sorption pump (46) in a liquid state, to re-enter said container (24).

2. The polarizer system (10) of claim 1 wherein the superconducting magnet is further configured to operate without quench or loss of liquid helium when disconnected from the cooling system (14) and operate in proximity to a magnetic resonance (MR) imaging field without degrading a homogeneity thereof.

3. The polarizer system (10) of any preceding claim wherein the sorption pump (46) further comprises:
a pump enclosure (78);
a sorbent material (80) housed within the pump enclosure; and
cooling fins (82) interspersed within the sorbent material (80) and connected to the thermal switch (84), wherein the cooling fins cool the sorbent material when the sorption pump (46) is in sorption mode.

4. The polarizer system (10) of any preceding claim further comprising a vacuum chamber (12) that encloses the polarizer system.

5. The polarizer system (10) of claim 4 further comprising an ante-chamber (32) attached to the vacuum chamber (12) to maintain a vacuum in the vacuum chamber when loading the material (22) to be polarized into the container (24).

6. The polarizer system (10) of any preceding claim further comprising:
a waveguide (48) positioned to transmit microwaves to the material (22) to be polarized; and
a nuclear magnetic resonance (NMR) coil (60) positioned within the container (24) and about the material (22) to be polarized, wherein the NMR coil is configured to detect a level of polarization of the material (22).

7. The polarizer system (10) of any preceding claim wherein the material (22) to be polarized is ¹³C₁-pyruvate.

8. A method for producing hyperpolarized material for use in magnetic resonance imaging (MRI) or nuclear magnetic resonance (NMR) spectroscopy systems comprising:
using the polarizer system (10) according to any preceding claim, by:
placing a material (22) in the container (24) containing a liquid helium bath;
reducing a temperature in the liquid helium bath by way of the sorption pump (46);
cooling the sorption pump (46) to promote molecular adsorption therein; and
selectively connecting the sorption pump (46) and the cooling system (14) using the thermally conductive link (72) and the thermal switch (84) that are operable to provide selective cooling to the sorption pump (46) in a closed cyclical thermal cycle alternating between a polarizing phase and a reheating phase so as to polarize the material (22) when the liquid helium bath has been sufficiently cooled.

9. The method of claim 8 wherein reducing temperature in the liquid helium bath further comprises:
lowering a pressure in the container (24) by way of the sorption pump (46); and
vaporizing a portion of the liquid helium bath at the lowered pressure.

10. The method of claim 9 further comprising recondensing the vaporized helium by way of the condenser unit (74) to refill the container (24) with liquid helium.

## Patentansprüche

1. Polarisatorsystem (10) zum Polarisieren eines Materials (22), das bei der Magnetresonanz- (MR)-Bilderzeugung verwendet werden soll, wobei das System Folgendes umfasst:
einen Behälter (24), der ein Flüssigheliumbad darin hat, wobei das zu polarisierende Material im Flüssigheliumbad positioniert wird;
eine Sorptionspumpe (46), die betrieben werden kann, um einen Druck im Behälter (24) zu reduzieren und dadurch einen Teil des Flüssigheliumbads zu verdampfen;
ein Kühlsystem (14), das betrieben werden kann, um die Sorptionspumpe (46) zu kühlen und die molekulare Adsorption darin zu fördern;
eine wärmeleitfähige Verbindung (72) zum selektiven Verbinden der Sorptionspumpe (46) und des Kühlsystems (14), um für das selektive Kühlen der Sorptionspumpe (46) zu sorgen;
wobei das Polarisatorsystem (10) zum Arbeiten in einem geschlossenen zyklischen Wärmekreisprozess ausgelegt ist, der zwischen einer polarisierenden Phase und einer Wiedererwärmungsphase auf der Basis der Verbindung der Sorptionspumpe (46) mit dem Kühlsystem (14) wechselt;
wobei das Polarisatorsystem (10) ferner einen thermischen Schalter (84) zum Verbinden und Trennen der thermisch leitfähigen Verbindung (72) von der Sorptionspumpe (46), wobei der thermische Schalter (84) zum Verbinden der thermisch leitfähigen Verbindung (72) mit der Sorptionspumpe (42) während der Polarisierungsphase und zum Trennen der thermisch leitfähigen Verbindung (72) von der Sorptionspumpe (42) während der Wiedererwärmungsphase betrieben werden kann;
eine magnetfelderzeugende Vorrichtung (28) zum Aufrechterhalten eines gewählten Magnetfeldes darin und wobei die magnetfelderzeugende Vorrichtung (28) vom Kühlsystem (14) gekühlt wird, wobei die magnetfelderzeugende Vorrichtung (28) ferner umfasst:
einen Magneten, der eine Bohrung durch denselben hat, mit Lage am Behälter (24); und
einen Magnetbehälter (70) zum Umschließen des Magneten, wobei der Magnetbehälter (70) flüssiges Helium darin zum Kühlen des Magneten enthält;
wobei das Polarisatorsystem (10) ferner einen Nachkondensator (74) umfasst, der am Magnetbehälter (70) befestigt ist, zum Nachkondensieren des flüssigen Heliums, das daraus abgesiedet ist;
**dadurch gekennzeichnet, dass**:
der Magnet ein superleitender Magnet ist und dadurch dass das Polarisatorsystem (10) einen Heliumkondensator (88) umfasst, der mit der Sorptionspumpe (46) mittels einer Pumpleitung (76) verbunden ist, wobei der Heliumkondensator (88) durch das Kühlsystem (14) gekühlt wird
durch eine gemeinsame Anschlussleitung (90), die an die thermisch leitfähige Verbindung (72) angeschlossen ist, wobei der Heliumkondensator (88) zum Nachkondensieren von Heliumgas ausgelegt ist, das aus dem Sorptionsmaterial in der Sorptionspumpe (46) in einem flüssigen Zustand freigesetzt wird, damit es wieder in den Behälter (24) eintritt.

2. Polarisatorsystem (10) nach Anspruch 1, wobei der superleitende Magnet ferner zum Arbeiten ohne Quench oder Verlust an flüssigem Helium ausgelegt ist, wenn er vom Kühlsystem (14) abgetrennt wird und in der Nähe eines Magnetresonanz- (MR)-Bildgebungsfeldes arbeitet, ohne eine Homogenität desselben herabzusetzen.

3. Polarisatorsystem (10) nach einem der vorherigen Ansprüche, wobei die Sorptionspumpe (46) ferner umfasst:
ein Pumpengehäuse (78);
ein Sorptionsmaterial (80), das im Pumpengehäuse untergebracht ist; und
Kühlrippen (82), verteilt innerhalb des Sorptionsmaterials (80) und mit dem thermischen Schalter (84) verbunden, wobei die Kühlrippen das Sorptionsmaterial kühlen, wenn die Sorptionspumpe (46) im Sorptionsmodus ist.

4. Polarisatorsystem (10) nach einem der vorherigen Ansprüche, das ferner eine Vakuumkammer (12) umfasst, die das Polarisatorsystem umschließt.

5. Polarisatorsystem (10) nach Anspruch 4, das ferner eine Vorkammer (32) umfasst, die an der Vakuumkammer (12) befestigt ist, um ein Vakuum in der Vakuumkammer aufrechtzuerhalten, wenn das zu polarisierende Material (22) in den Behälter (24) geladen wird.

6. Polarisatorsystem (10) nach einem der vorherigen Ansprüche, das ferner Folgendes umfasst:
einen Wellenleiter (48), der zum Senden von Mikrowellen an das zu polarisierende Material (22) angeordnet ist; und
eine Kernspinresonanz-(NMR)-Spule (60), die innerhalb des Behälters (24) und um das zu polarisierende Material (22) positioniert ist, wobei die NMR-Spule zum Feststellen eines Grades der Polarisation des Materials (22) ausgelegt ist.

7. Polarisatorsystem (10) nach einem der vorherigen Ansprüche, wobei das Material (22), das polarisiert werden soll, ¹³C₁-Pyruvat ist.

8. Verfahren zum Herstellen von hyperpolarisiertem Material zur Verwendung in der Magnetresonanz-Bilderzeugung (MRI) oder Kernmagnetresonanz- (NMR)-Spektroskopiesystemen, umfassend: Verwendung des Polarisatorsystems (10) nach einem der vorherigen Ansprüche, durch:
Platzieren eines Materials (22) im Behälter (24), der ein Flüssigheliumbad enthält; Reduzieren einer Temperatur im Flüssigheliumbad durch eine Sorptionspumpe (46);
Kühlen der Sorptionspumpe (46), um die molekulare Adsorption darin zu fördern; und
selektives Verbinden der Sorptionspumpe (46) und des Kühlsystems (14) unter Verwendung der thermisch leitfähigen Verbindung (72) und Wärmeschalters (84), die betrieben werden können, um für eine selektive Kühlung für die Sorptionspumpe (46) in einem geschlossenen zyklischen Thermozyklus zu sorgen, der zwischen einer polarisierenden Phase und einer Wiedererwärmungsphase wechselt, um so das Material (22) zu polarisieren, wenn das Flüssigheliumbad ausreichend gekühlt wurde.

9. Verfahren nach Anspruch 8, wobei das Reduzieren der Temperatur im Flüssigheliumbad ferner umfasst:
Absenken eines Drucks im Behälter (24) mittels der Sorptionspumpe (46); und Verdampfen eines Teils des Flüssigheliumbades beim abgesenkten Druck.

10. Verfahren nach Anspruch 9, das ferner des erneute Kondensieren des verdampften Heliums mittels der Verflüssigereinheit (74) umfasst, um den Behälter (24) wieder mit flüssigem Helium aufzufüllen.

## Revendications

1. Système de polariseur (10) pour polariser une matière (22) à utiliser dans une imagerie par résonance magnétique (RM), le système comprenant :
un conteneur (24) ayant un bain d'hélium liquide en son sein, dans lequel la matière à polariser est positionnée dans le bain d'hélium liquide ;
une pompe à sorption (46) pouvant être mise en oeuvre pour réduire une pression dans le conteneur (24) et vaporiser de ce fait une partie du bain d'hélium liquide ;
un système de refroidissement (14) pouvant être mis en oeuvre pour refroidir la pompe à sorption (46) et favoriser l'adsorption moléculaire en son sein ;
une liaison thermiquement conductrice (72) pour relier de manière sélective la pompe à sorption (46) et le système de refroidissement (14) pour fournir un refroidissement sélectif à la pompe à sorption (46) ;
dans lequel le système de polariseur (10) est agencé pour fonctionner dans un cycle thermique cyclique fermé alternant entre une phase de polarisation et une phase de réchauffage basée sur la connexion de la pompe à sorption (46) au système de refroidissement (14) ;
ledit système de polariseur (10) comprenant en outre un commutateur thermique (84) pour relier et débrancher la liaison thermiquement conductrice (72) de la pompe à sorption (46), dans lequel le commutateur thermique (84) peut être mis en oeuvre pour relier la liaison thermiquement conductrice (72) à la pompe à sorption (42) pendant la phase de polarisation et débrancher la liaison thermiquement conductrice (72) de la pompe à sorption (42) pendant la phase de réchauffage ;
un dispositif de production de champ magnétique (28) pour maintenir un champ magnétique sélectionné en son sein et dans lequel le dispositif de production de champ magnétique (28) est refroidi par le système de refroidissement (14), dans lequel le dispositif de production de champ magnétique (28) comprend en outre :
un aimant ayant un alésage à travers ce dernier positionné autour du conteneur (24) ; et
un conteneur d'aimant (70) pour englober l'aimant, le conteneur d'aimant (70) contenant de l'hélium liquide en son sein pour refroidir l'aimant ;
le système de polariseur (10) comprenant en outre un recondenseur (74) attaché au conteneur d'aimant (70) pour recondenser l'hélium liquide évaporé par ébullition à partir de là ;
**caractérisé en ce que** :
l'aimant est un aimant supraconducteur, et **en ce que** le système de polariseur (10) comprend un condenseur d'hélium (88) relié à la pompe à sorption (46) à l'aide d'une conduite de pompage (76), ledit condenseur d'hélium (88) étant refroidi par ledit système de refroidissement (14) par l'intermédiaire de bus communs (90) reliés à la liaison thermiquement conductrice (72), le condenseur d'hélium (88) étant agencé pour recondenser le gaz d'hélium libéré de la matière de sorbant dans la pompe à sorption (46) dans un état liquide, pour entrer de nouveau dans ledit conteneur (24).

2. Système de polariseur (10) selon la revendication 1, dans lequel l'aimant supraconducteur est en outre configuré pour fonctionner sans refroidissement rapide ou perte d'hélium liquide quand débranché du système de refroidissement (14) et pour fonctionner à proximité d'un champ d'imagerie par résonance magnétique (RM) sans dégradation de son homogénéité.

3. Système de polariseur (10) selon n'importe quelle revendication précédente, dans lequel la pompe à sorption (46) comprend en outre :
une enveloppe de pompe (78) ;
une matière de sorbant (80) logée à l'intérieur de l'enveloppe de pompe ; et
des ailettes de refroidissement (82) intercalées dans la matière de sorbant (80) et reliées au commutateur thermique (84), dans lequel les ailettes de refroidissement refroidissent la matière de sorbant lorsque la pompe à sorption (46) est dans le mode de sorption.

4. Système de polariseur (10) selon n'importe quelle revendication précédente comprenant en outre une chambre à vide (12) qui englobe le système de polariseur.

5. Système de polariseur (10) selon la revendication 4, comprenant en outre une antichambre (32) attachée à la chambre à vide (12) pour maintenir un vide dans la chambre à vide en chargeant la matière (22) à polariser dans le conteneur (24).

6. Système de polariseur (10) selon n'importe quelle revendication précédente comprenant en outre :
un guide d'ondes (48) positionné pour transmettre des micro-ondes à la matière (22) à polariser ; et
une bobine de résonance magnétique nucléaire (RMN) (60) positionnée à l'intérieur du conteneur (24) et autour de la matière (22) à polariser, dans lequel la bobine de RMN est configurée pour détecter un niveau de polarisation de la matière (22).

7. Système de polariseur (10) selon n'importe quelle revendication précédente dans lequel la matière (22) à polariser est du ¹³C₁-pyruvate.

8. Procédé pour produire de la matière hyperpolarisée à utiliser dans des systèmes de spectroscopie à imagerie par résonance magnétique (IRM) ou par résonance magnétique nucléaire (RMN) comprenant :
l'utilisation du système de polariseur (10) selon n'importe quelle revendication précédente, par :
placement d'une matière (22) dans le conteneur (24) contenant un bain d'hélium liquide ;
réduction d'une température dans le bain d'hélium liquide à l'aide de la pompe à sorption (46) ;
refroidissement de la pompe à sorption (46) pour favoriser l'adsorption moléculaire en son sein ; et
connexion sélective de la pompe à sorption (46) et du système de refroidissement (14) en utilisant la liaison thermiquement conductrice (72) et le commutateur thermique (84) qui peuvent être mis en oeuvre pour fournir un refroidissement sélectif à la pompe à sorption (46) dans un cycle thermique cyclique fermé alternant entre une phase de polarisation et une phase de réchauffage afin de polariser la matière (22) quand le bain d'hélium liquide a été suffisamment refroidi.

9. Procédé selon la revendication 8, dans lequel la réduction de température dans le bain d'hélium liquide comprend en outre :
l'abaissement d'une pression dans le conteneur (24) à l'aide de la pompe à sorption (46) ; et
la vaporisation d'une partie du bain d'hélium liquide à la pression abaissée.

10. Procédé selon la revendication 9 comprenant en outre la recondensation de l'hélium vaporisé à l'aide de l'unité de condenseur (74) pour remplir de nouveau le conteneur (24) avec de l'hélium liquide.
